# EUROPÄISCHE PATENTSCHRIFT

(11) **EP 2 664 014 B1**
(45) Veröffentlichungstag und Bekanntmachung des Hinweises auf die Patenterteilung: **15.08.2018**
(21) Anmeldenummer: 12700939.7
(22) Anmeldetag: 04.01.2012
(51) Int. Cl.: H01L 35/32

(54) **THERMOELEKTRISCHES MODUL MIT MITTELN ZUR KOMPENSATION EINER WÄRMEAUSDEHNUNG**
THERMOELECTRIC MODULE WITH MEANS FOR COMPENSATING FOR A THERMAL EXPANSION
MODULE THERMOÉLECTRIQUE DOTÉ DE MOYENS DE COMPENSATION D'UNE DILATATION THERMIQUE

(30) Priorität: 12.01.2011 DE 102011008378
(43) Veröffentlichungstag der Anmeldung: 20.11.2013
(73) Patentinhaber: Continental Automotive GmbH, 30165 Hannover (DE)
(72) Erfinder: LIMBECK, Sigrid, 53804 Much (DE); BRÜCK, Rolf, 51429 Bergisch Gladbach (DE)
(86) Internationale Anmeldenummer: PCT/EP2012/050106
(87) Internationale Veröffentlichungsnummer: WO 2012/095344

(56) Entgegenhaltungen:
- WO-A1-2005/021198
- DE-A1-102009 003 144
- DE-A1-102009 009 586
- FR-A- 1 198 118
- JP-A- 2001 060 725
- US-A1- 2003 140 957

## Beschreibung

Die vorliegende Erfindung betrifft ein thermoelektrisches Modul mit einer rohrförmigen Ausgestaltung. Das thermoelektrische Modul wird zum Aufbau eines thermoelektrischen Generators eingesetzt, der zur Umwandlung thermischer Energie eines Abgases in elektrische Energie geeignet ist.

Das Abgas aus einem Motor eines Kraftfahrzeugs besitzt thermische Energie, welche mittels eines thermoelektrischen Generators in elektrische Energie umgewandelt werden kann, bspw. um eine Batterie oder einen anderen Energiespeicher zu füllen oder elektrischen Verbrauchern die benötigte Energie direkt zuzuführen. Damit wird das Kraftfahrzeug mit einem verbesserten energetischen Wirkungsgrad betrieben, und es steht für den Betrieb des Kraftfahrzeugs Energie in größerem Umfang zur Verfügung.

Ein solcher thermoelektrischer Generator weist zumindest ein thermoelektrisches Modul auf, wobei regelmäßig eine Mehrzahl solcher (gleichartig aufgebauter) Module elektrisch so verschaltet ist, dass sie gemeinsam einen thermoelektrischen Generator bilden. Thermoelektrische Materialien hierfür sind von einer Art, dass diese effektiv thermische Energie in elektrische Energie umwandeln können (Seebeck-Effekt) und umgekehrt (Peltier-Effekt). Solche thermoelektrischen Module weisen bevorzugt eine Vielzahl von thermoelektrischen Elementen auf, die zwischen einer sogenannten Heißseite und einer sogenannten Kaltseite positioniert sind. Thermoelektrische Elemente umfassen z. B. wenigstens zwei Halbleiterelemente, die p- und n-dotiert sind und zusammen die kleinste thermoelektrische Einheit bilden. Diese Halbleiterelemente sind auf ihrer Ober- und Unterseite (hin zur Heißseite bzw. zur Kaltseite) wechselseitig mit elektrisch leitenden Brücken versehen, so dass jeweils n- und p-dotierte Halbleiterelemente miteinander verbunden sind. Üblicherweise werden diese elektrisch leitenden Brücken gegenüber einem die thermoelektrischen Elemente aufnehmenden Gehäuse elektrisch isoliert. Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind insbesondere zahlreiche Halbleiterelemente elektrisch in Reihe geschaltet. Damit sich die generierte Potentialdifferenz der seriellen Halbleiterelemente nicht gegenseitig aufhebt, sind stets wechselweise Halbleiterelemente mit unterschiedlichen Majoritätsladungsträgern (n- und p-dotiert) in direkten elektrischen Kontakt gebracht. Mittels eines angeschlossenen Lastwiderstands kann der Stromkreis geschlossen und somit elektrische Leistung abgegriffen werden.

Für den Einsatz in Kraftfahrzeugen sind insbesondere rohrförmige thermoelektrische Module geeignet, in denen Halbleiterelemente kreisringförmig hintereinander zwischen einem Innenrohr und einem Außenrohr angeordnet sind, wobei das Innenrohr oder das Außenrohr von einem Abgas oder einem heißen Medium überströmt wird. In Folge des über dem thermoelektrischen Modul anliegenden Temperaturpotentials wird das thermoelektrische Modul mit unterschiedlichen Wärmeausdehnungen einzelner Komponenten belastet. Um ein dauerfestes thermoelektrisches Modul bereitzustellen, müssen diese unterschiedlichen Wärmeausdehnungen innerhalb des thermoelektrischen Moduls bzw. innerhalb eines thermoelektrischen Generators kompensiert werden.

Die DE-A1-10 2009 009 586 ist auf ein rohrförmiges thermoelektrisches Modul gerichtet, in dem ringförmige thermoelektrische Elemente hintereinander entlang einer axialen Erstreckung angeordnet und an einem Außenrohr und an einem Innenrohr wechselweise elektrisch leitend miteinander verbunden sind.

US2003/0140957 A1 und FR1198118 A offenbaren ein thermoelektrisches Modul mit Streifenförmigen Strukturen zur Anbindung am Innen- und Außenrohr. Hiervon ausgehend ist es Aufgabe der vorliegenden Erfindung, die mit Bezug auf den Stand der Technik geschilderten Probleme zumindest teilweise zu lösen. Insbesondere soll ein rohrförmiges thermoelektrisches Modul angegeben werden, das die unterschiedlichen Wärmeausdehnungen einzelner Komponenten des thermoelektrischen Moduls kompensieren kann und so eine hohe Dauerfestigkeit des thermoelektrischen Moduls auch im Betrieb erreicht. Dadurch soll ein temperaturbeständiges und dauerfestes thermoelektrisches Modul herstellbar sein.

Diese Aufgaben werden gelöst mit einem thermoelektrischen Modul gemäß den Merkmalen des Patentanspruchs 1.

Das erfindungsgemäße thermoelektrische Modul erstreckt sich in einer Längsrichtung und weist ein Außenrohr und ein innerhalb des Außenrohrs angeordnetes Innenrohr auf sowie einen dazwischen angeordneten Zwischenraum. Darüber hinaus sind zumindest eine erste streifenförmige Struktur und eine zweite streifenförmige Struktur vorgesehen, wobei die erste streifenförmige Struktur sich ausgehend von einer ersten Anbindung am Innenrohr und die zweite streifenförmige Struktur sich ausgehend von einer zweiten Anbindung an einem Außenrohr in jeweils entgegengesetzten Richtungen in einer radialen Richtung hin zum gegenüberliegenden Rohr und zusätzlich zumindest in eine Umfangsrichtung oder der Längsrichtung erstrecken und zumindest in Umfangsrichtung oder in Längsrichtung wenigstens teilweise eine Überdeckung ausbilden. Im Bereich dieser Überdeckung ist zumindest ein Halbleiterelement oder ein Paar Halbleiterelemente angeordnet wobei die erste Anbindung und die zweite Anbindung schräg zur Umfangsrichtung bzw. zur Längsrichtung des thermoelektrischen Moduls angeordnet sind. Das Modul ist hierbei insbesondere nach Art eines Doppelrohres ausgeführt, wobei Außenrohr und Innenrohr konzentrisch zueinander angeordnet sind und der Ringspalt dazwischen als Zwischenraum dient, in dem die thermoelektrischen Elemente vorgesehen sind. Die Rohrform ist bevorzugt im Wesentlichen zylindrisch, dies ist aber nicht zwingend erforderlich. So können insbesondere auch rechteckige oder quadratische Rohrformen eingesetzt werden, die teilweise sogar noch bessere Ergebnisse hinsichtlich der Spannungsminimierung und/oder der Fertigungsgenauigkeit zur Folge haben. Hierbei ist es insbesondere unerheblich, ob die sogenannte Heißseite an dem Außenrohr oder dem Innenrohr angeordnet ist.

Insbesondere sind die ersten und/oder zweiten streifenförmigen Strukturen durch metallische Blechstreifen gebildet, die zwischen zwei Enden eine Länge, zwischen zwei Seiten eine Breite sowie zwischen zwei Oberflächen eine Dicke bilden. Die Überdeckung der streifenförmigen Strukturen bezieht sich auf zumindest einen Teil der Länge und einen Teil der Breite der jeweils betrachteten Paare aus einer ersten und einer zweiten streifenförmigen Struktur. Die zweiten streifenförmigen Strukturen sind mit einem ihrer Enden mit dem Außenrohr verbunden, während die ersten streifenförmigen Strukturen ihrerseits mit einem Ende mit dem Innenrohr verbunden sind. Die erste und/oder zweite Anbindung ist dabei bevorzugt stoffschlüssig (insbesondere mittels einer Schweißnaht oder durch eine Lötverbindung) ausgeführt. Eine stoffschlüssige Verbindung liegt dann vor, wenn die Verbindungspartner durch atomare und/oder molekulare Kräfte zusammengehalten werden. Das jeweils andere Ende der streifenförmigen Strukturen ragt in den Zwischenraum hinein. Insbesondere erstrecken sich die streifenförmigen Strukturen hierfür zumindest teilweise in Längsrichtung und/oder in Umfangsrichtung der Rohre, ggf. zudem auch noch in radialer Richtung auf das gegenüberliegende Rohr zu. Dabei überlappt sich zumindest ein Paar aus erster und zweiter streifenförmiger Struktur (zumindest teilweise). Dieser Bereich der Überdeckung wird nun genutzt, dazwischen Halbleiterelemente zu positionieren, die folglich mit den streifenförmigen Strukturen einerseits mit der Heißseite und andererseits mit der Kaltseite in wärmeleitendem Kontakt stehen.

Auf der Oberfläche der streifenförmigen Strukturen sind die Halbleiterelemente angeordnet, die insbesondere direkt auf den streifenförmigen Strukturen z. B. durch ein Druckverfahren aufgebaut werden. Insbesondere erfolgt dieser Aufbau der Halbleiterelemente auf den streifenförmigen Strukturen schichtweise, so dass Halbleiterelemente mit unterschiedlichen Eigenschaften hinsichtlich der Temperaturbeständigkeit, Wärmeleitung oder ähnlichem für den jeweiligen Anwendungsfall und Einbauort ausgelegt werden können. Insbesondere sind die Halbleiterelemente, die im Bereich der Überdeckung angeordnet werden, quaderförmig, zylinderförmig und/oder kreisringsegmentförmig ausgeführt. Als Druckverfahren zum Auftragen der Halbleiterelemente kann insbesondere eines der folgenden Verfahren eingesetzt werden: Drop-on-Demand, Continuous Inkjet, Bubble-Jet. Diese Verfahren sind unter anderem auch aus dem technischen Umfeld des Auftragens einer Schicht zum Löten von metallischen Wabenkörpern bekannt (siehe z. B. WO-A1-2005021198, die als Beispiel hier zur Darstellung der Verfahren vollumfänglich herangezogen werden kann). Ebenso können diese Verfahren auch zum Auftragen von Halbleitermaterial auf den hier genannten streifenförmigen Strukturen eingesetzt werden. Insbesondere werden die streifenförmigen Strukturen als Endlosmaterial bereitgestellt, so dass die Halbleitermaterialien in einem kostengünstigen und hochproduktiven Herstellungsverfahren aufgetragen werden können. Die streifenförmigen Strukturen werden erst danach auf die erforderlichen Dimensionen zugeschnitten, bzw. durch ein entsprechendes Trennverfahren.

Um n-dotierte und p-dotierte Halbleiterelemente entsprechend elektrisch wechselweise miteinander elektrisch zu verschalten, so dass ein thermoelektrisches Element erzeugt wird, sind auf den streifenförmigen Strukturen insbesondere elektrisch leitende Brücken bzw. elektrische Leiterstrukturen angeordnet. Die streifenförmigen Strukturen sind bevorzugt metallisch und weisen eine elektrische Isolation auf, die die elektrischen Leiterstrukturen von den streifenförmigen Strukturen isoliert. Insbesondere wird auf jedem Paar aus erster und zweiter streifenförmiger Struktur nur jeweils ein thermoelektrisches Element angeordnet, so dass die thermoelektrischen Elemente auf den einzelnen Paaren streifenförmiger Strukturen ebenfalls parallel oder seriell miteinander verschaltbar sind. Es ist natürlich auch möglich, auf jedem Paar streifenförmiger Strukturen nur ein einziges Halbleiterelement anzuordnen, so dass erst durch das elektrische Verschalten mit einem weiteren Paar streifenförmiger Strukturen ein thermoelektrisches Element gebildet ist. Insbesondere weisen die streifenförmigen Strukturen eine so große Breite auf, dass eine Vielzahl von thermoelektrischen Elementen in Richtung der Breite hintereinander angeordnet und seriell miteinander elektrisch verbunden werden können. Die jeweils zwei Halbleiterelemente, die zu einem thermoelektrischen Element zusammengefasst werden, sind dabei bevorzugt in Richtung der Länge nebeneinander angeordnet. Insbesondere sind mehr als ein thermoelektrisches Element in Richtung der Länge der streifenförmigen Struktur nebeneinander seriell oder parallel geschaltet angeordnet, so dass eine hohe Raumausnutzung des Zwischenraums zwischen Außenrohr und Innenrohr durch die thermoelektrischen Elemente gewährleistet ist.

Die über Halbleiterelemente miteinander verbundenen streifenförmigen Strukturen bilden demnach eine Art Verbindungsbrücke für die beiden Rohre. Diese Verbindungsbrücke ist nun in der Lage, die Ausdehnung zumindest eines Rohres in eine Bewegung eines Rohres zu überführen, bzw. die Ausdehnung zumindest eines Rohres so auszugleichen, das eine Bewegung zumindest eines Rohres nicht eine Beeinträchtigung der Funktion des thermoelektrischen Moduls zur Folge hat, indem z. B. die zwischen den Rohren angeordneten Halbleiterelemente oder deren elektrischen Leiterstrukturen beschädigt werden. Dabei sind die Verbindungsbrücken bevorzugt so ausgeführt, dass Wärmeausdehnungen nicht nur mit den Bauteilen im Zwischenraum kompensiert werden, sondern zumindest teilweise auch in eine relative Bewegung des Innenrohres gegenüber dem Außenrohr überführt werden. Anders ausgedrückt wird die Wärmeausdehnung der einzelnen Bauteile des thermoelektrischen Moduls ggf. dadurch kompensiert, dass diese von den streifenförmigen Strukturen vollkommen aufgenommen bzw. kompensiert werden und/oder dass sich zumindest Außenrohr und Innenrohr relativ zueinander bewegen können und diese Bewegung durch die Bauteile im Zwischenraum (also streifenförmige Strukturen, Halbleiterelemente usw.) so kompensiert wird, dass Spannungen abgebaut werden und Beschädigungen der Bauteile des thermoelektrischen Moduls unterbleiben. Die Orientierung bzw. Ausrichtung der streifenförmigen Strukturen in Längsrichtung erlaubt so beispielsweise eine axiale Verschiebung und/oder die Orientierung bzw. Ausrichtung der streifenförmigen Strukturen in Umfangsrichtung eine Verdrehung der Rohre zueinander, weil die Längenausdehnung dieser Streifen, bzw. die Ausdehnung zumindest eines Rohres zu einer entsprechenden relativen Bewegung führt bzw. diese Bewegung erlaubt (indem so Spannungen innerhalb des thermoelektrischen Moduls abgebaut werden). Dabei ist zu beachten, dass der mittige Bereich mit den Halbleiterelementen dann besonders spannungsarm im Betrieb trotz der thermischen Wechselbeanspruchung gehalten werden kann.

Auch wenn vorstehend komplexe (also insbesondere gemeinsame und/oder gleichzeitige) Ausgleichsbewegung zwischen Außenrohr, Innenrohr und den Komponenten im Zwischenraum beschrieben sind, so kann die Ausgleichbewegung vorrangig oder sogar (im Wesentlichen) ausschließlich von den Komponenten im Zwischenraum durchgeführt werden.

Gemäß einer Ausführungsvariante sind das Außenrohr und das Innenrohr so zueinander angeordnet, dass eine thermische Ausdehnung des thermoelektrischen Moduls durch eine relative Bewegung des Außenrohrs gegenüber dem Innenrohr kompensiert wird. Insbesondere ist hiermit umfasst, dass sich das ganze Innenrohr gegenüber dem Außenrohr bewegt oder umgekehrt, d. h. dass insbesondere an keiner Stelle das Außenrohr gegenüber dem Innenrohr hinsichtlich seiner Positionierung starr fixiert ist.

Außenrohr und Innenrohr sind dabei so miteinander (direkt oder mittelbar) verbunden und/oder so gelagert, dass sie sich insgesamt gegeneinander relativ bewegen können, wenn sie infolge einer Temperaturbeanspruchung wachsen und/oder schrumpfen. Das bedeutet insbesondere, dass eine Lageverschiebung von Innenrohr und Außenrohr ermöglicht ist, wodurch eine Spannungsminimierung zwischen diesen Rohren erfolgt.

Eine thermische Ausdehnung der einzelnen Komponenten (Außenrohr, Innenrohr, Halbleiterelemente, usw.) des rohrförmigen Moduls bewirkt also gegebenenfalls zusätzlich eine (relative) Bewegung in einer Umfangsrichtung (also z. B. mit einer Verdrehung bzw. Rotation relativ zueinander) und/oder in einer Längsrichtung (also z. B. mit einer axialen Verschiebung relativ zueinander) und/oder in einer radialen Richtung des thermoelektrischen Moduls. Das bedeutet insbesondere, dass zumindest eines der Elemente Innenrohr oder Außenrohr bei einer thermischen Beanspruchung eine Bewegung ausführt, oder insbesondere beide relativ zueinander. Durch diese (relative) Bewegung werden auch Wärmespannungen innerhalb des thermoelektrischen Moduls abgebaut, so dass insbesondere die üblicherweise sehr spröden Halbleiterelemente nicht beschädigt werden und somit ein dauerfestes thermoelektrisches Modul hergestellt ist.

Dieses Konzept der gegeneinander relativ bewegbaren Rohre kann auch unabhängig von der Gestaltung des Moduls mit den streifenförmigen Strukturen und dem Paar Halbleiterelemente im Überdeckungsbereich realisiert werden, so dass die eingangs genannten Aufgaben (unabhängig davon) auch von dem nachfolgend beschriebenen thermoelektrischen Modul gelöst werden:
Rohrförmiges thermoelektrisches Modul, das sich in einer Längsrichtung erstreckt, mit einem Außenrohr und einem innerhalb des Außenrohrs angeordneten Innenrohr sowie einem dazwischen angeordneten Zwischenraum, wobei das Außenrohr und das Innenrohr so zueinander angeordnet sind, dass eine thermische Ausdehnung des Moduls durch eine relative Bewegung des Außenrohres gegenüber dem Innenrohr kompensiert wird.

Zur Erläuterung dieses grundlegenden Konzepts kann vollumfänglich auf die obigen und nachfolgenden Beschreibungen hierzu zurückgegriffen

Weiterhin sind die erste Anbindung und die zweite Anbindung schräg zur Umfangsrichtung und/oder schräg zur Längsrichtung des thermoelektrischen Moduls angeordnet. Bei einer solchen Orientierung bzw. Ausrichtung der Anbindungen kann eine größere Länge der streifenförmigen Strukturen durch einen Verbindungsprozess (z. B. Hart- oder Weichlöten oder Schweißen) mit dem Innenrohr bzw. dem Außenrohr verbunden werden, wodurch der Fertigungsaufwand reduziert werden kann. Dies gilt insbesondere dann, wenn möglichst wenige streifenförmigen Strukturen eingesetzt und trotzdem eine hohe Raumausnutzung für die Halbleiterelemente im Zwischenraum erreicht werden soll. Eine weitere Ausgestaltung des erfindungsgemäßen thermoelektrischen Moduls umfasst, dass sich das thermoelektrische Modul in einer Längsrichtung erstreckt und ein Außenrohr und ein innerhalb des Außenrohrs angeordnetes Innenrohr aufweist sowie einen dazwischen angeordneten Zwischenraum. Das Außenrohr und das Innenrohr sind so zueinander angeordnet, dass eine thermische Ausdehnung des Moduls durch in dem Zwischenraum angeordnete Komponenten kompensiert wird. Insbesondere sind die in dem Zwischenraum angeordneten thermoelektrischen Elemente so anzuordnen, dass die durch die unterschiedliche thermische Ausdehnung hervorgerufene relative Bewegung der Rohre zueinander nicht zu einer Beschädigung der im Zwischenraum angeordneten Bauteile führt. Bevorzugt wird die relative Bewegung von Außenrohr gegenüber Innenrohr also ausschließlich durch die im Zwischenraum angeordneten Komponenten des thermoelektrischen Moduls kompensiert. Aufgrund der prinzipbedingten Temperaturdifferenz kommt es zu Differenzdehnungen zwischen dem Innenrohr und dem Außenrohr, die im Hinblick auf eine Spannungsminimierung auch soweit wie möglich zugelassen werden sollen. Die Lösung besteht nun darin, die dazwischen liegenden spannungsempfindlichen Halbleiterelemente so anzuordnen (alleine und/oder auf entsprechend ausgeführten "Trägern" bzw. streifenförmigen Strukturen), dass sie die Relativbewegung der beiden Rohre möglichst gut (mit möglichst geringer Belastung) mitmachen. Die angesprochenen Komponenten umfassen insbesondere zumindest die Halbleiterelemente und/oder entsprechend ausgeführte Träger bzw. streifenförmige Strukturen, auf denen die Halbleiterelemente angeordnet sind.

Die Kompensation der unterschiedlichen Wärmeausdehnung wird bevorzugt gerade nicht durch konstruktive Maßnahmen am Außenrohr oder Innenrohr gewährleistet (z. B. durch Falzungen o.ä.), sondern ausschließlich durch eine relative Bewegung von Außenrohr gegenüber Innenrohr und/oder durch eine entsprechende Anordnung bzw. Ausgleichsbewegung der im Zwischenraum angeordneten Komponenten.

Gemäß einer weiteren besonders bevorzugten Ausgestaltung des thermoelektrischen Moduls verlaufen die ersten Anbindungen auf dem Innenohr und die zweiten Anbindungen auf dem Außenrohr wendelförmig. Ganz besonders bevorzugt ist dabei, dass alle ersten streifenförmigen Strukturen mit einer einzigen wendelförmigen ersten Anbindung am Innenrohr und/oder alle zweiten streifenförmigen Strukturen mit einer einzigen wendelförmigen zweiten Anbindung am Außenrohr befestigt (insbesondere verschweißt oder verlötet) sind.

Durch die Anordnung der Halbleiterelemente auf den streifenförmigen Strukturen, die im Zwischenraum zwischen Außenrohr und Innerohr angeordnet sind, kann eine Wärmeausdehnung des thermoelektrischen Moduls in zumindest einer radialen Richtung über die streifenförmigen Strukturen federnd abgefangen werden. Eine Ausdehnung in Längsrichtung des thermoelektrischen Moduls durch eine der Komponenten Außenrohr oder Innenrohr, bzw. durch beide Rohre relativ zueinander, kann entweder durch eine Anordnung der streifenförmigen Strukturen kompensiert werden, wobei deren Enden jeweils in diese Längsrichtung weisen oder durch eine schräge Anordnung der streifenförmigen Strukturen zur Längsrichtung, wobei dann aber nur ein Teil der unterschiedlichen Wärmeausdehnung in Längsrichtung kompensiert wird. Der weitere Teil der zu kompensierenden Wärmeausdehnung wird dann in radialer Richtung und/oder in Umfangsrichtung des thermoelektrischen Moduls aufgenommen. Bei der Kompensation dieser unterschiedlichen Wärmeausdehnungen wird das Innenrohr gegenüber dem Außenrohr bewegt. Ebenso kann die Bewegung aufgrund der jeweils eintretenden Wärmedehnung von Innenrohr und Außenrohr einsetzen und die sie verbindenden streifenförmigen Strukturen bzw. die Halbleiterelemente weichen entsprechend aus. Die streifenförmigen Strukturen können eine Wärmespannung in radialer Richtung federnd kompensieren. Eine in Umfangsrichtung oder in Längsrichtung des thermoelektrischen Moduls verlaufende Wärmeausdehnung, die gleichzeitig gegenüber den Halbleiterelementen eine Scherspannung bedeutet, wird aber durch die Bewegung des Innenrohrs gegenüber dem Außenrohr und durch eine entsprechende Verkippung der streifenförmigen Strukturen abgebaut. Aus diesem Grund kann zumindest eine Komponente der Gruppe Außenrohr oder Innenrohr beweglich ausgeführt sein, so dass die relative Bewegung von Innenrohr gegenüber Außenrohr ermöglicht wird.

Bei dieser beweglichen Anordnung des Innenrohrs und/oder des Außenrohrs des thermoelektrischen Moduls sind insbesondere die Anschlüsse des Innenrohrs bzw. des Außenrohrs innerhalb eines thermoelektrischen Generators zu beachten, wobei die Dichtigkeit insbesondere des Zwischenraums aber auch die Dichtheit der Heißseite gegenüber der Kaltseite aufrecht erhalten werden sollte. Aus diesem Grund ist insbesondere ein Schiebesitz für das Innenrohr und/oder das Außenrohr an dem jeweiligen Rohrende vorzusehen, so dass sich dieses gegenüber einer Aufnahme oder einem Gehäuse eines thermoelektrischen Generators in einem geringen Maß bewegen kann, ohne die Dichtheit des thermoelektrischen Moduls selbst bzw. die Dichtheit der Heißseite gegenüber der Kaltseite zu beeinträchtigen.

Gemäß einer weiteren besonders vorteilhaften Ausgestaltung des thermoelektrischen Moduls sind zumindest in Umfangsrichtung oder in Längsrichtung des thermoelektrischen Moduls mehrere erste streifenförmige Strukturen und mehrere zweite streifenförmige Strukturen angeordnet. Insbesondere wird vorgeschlagen, dass jeweils mindestens sechs (6) Paare aus ersten und zweiten streifenförmige Strukturen in Umfangsrichtung hintereinander angeordnet sind, die sich insbesondere wendelförmig, also in Längsrichtung und in Umfangsrichtung des thermoelektrischen Moduls, durch das gesamte thermoelektrische Modul erstrecken und somit eine Vielzahl von Halbleiterelementen zwischen der jeweils ersten streifenförmigen Struktur und der jeweils zweiten streifenförmigen Struktur aufnehmen. Insbesondere sind somit je Paar mehr als 20, insbesondere mehr als 50 und in besonders vorteilhafter Weise mehr als 100 thermoelektrische Elemente angeordnet. Diese Vielzahl von thermoelektrischen Elementen kann z. B. durch ein Druckverfahren auf insbesondere endlose streifenförmige Strukturen aufgetragen werden, die nach dem Bedrucken mit zumindest den Halbleitermaterialien zu entsprechenden ersten und/oder zweiten streifenförmigen Strukturen mit der gewünschten Länge bzw. Breite abgetrennt werden.

Auch wenn bevorzugt ist, dass das Innenrohr und/oder das Außenrohr ein separates Bauteil ist, so ist das nicht zwingend erforderlich. So kann ein solches Innenrohr/Außenrohr auch (teilweise) mit den streifenförmigen Strukturen selbst gebildet sein, z. B. indem diese streifenförmigen Strukturen an einem Endbereich zu einem stabilen Rohr aufgewickelt ausgeführt sind. Dann bildet ein Endbereich der streifenförmigen Strukturen zumindest teilweise das jeweilige Rohr und der andere Endbereich der streifenförmigen Strukturen die Überdeckung mit den Halbleiterelementen aus. Insbesondere sind mehrere streifenförmige Strukturen nebeneinander angeordnet und werden spiralförmig gewickelt, so dass ein Innenrohr oder Außenrohr mit entsprechenden Überdeckungen für die Halbleiterelemente gebildet ist.

Der Zwischenraum zwischen Innenrohr und Außenrohr ist insbesondere durch Luft, Vakuum oder eine Schutzgasatmosphäre gefüllt, so dass eine Wärmeausdehnung der einzelnen Komponenten in radialer Richtung, in Längsrichtung und in Umfangsrichtung, aber auch ein Federn der streifenförmigen Strukturen in der radialen Richtung ohne Einschränkung möglich ist. Durch Luft, Vakuum oder eine Schutzgasatmosphäre wird gleichzeitig eine elektrische Isolierung zwischen den Halbleiterelementen sowie eine gute thermische Isolierung zwischen Heißseite und Kaltseite gewährleistet.

Der Füllgrad des Zwischenraums mit Halbleiterelementen liegt bevorzugt in einem Bereich von 20 % bis 80 %, insbesondere in einem Bereich von 20 % bis 40 %. Der Füllgrad des Zwischenraums bezieht sich dabei auf das Volumen zwischen Innenrohr und Außenrohr, das theoretisch ohne streifenförmige Strukturen durch Halbleitermaterial vollständig ausgefüllt sein könnte. Ein zwischen Innenrohr und Außenrohr durch Halbleitermaterial vollständig ausgefüllter Zwischenraum hätte entsprechend einen Füllgrad von 100 %.

Weiterhin wird ein thermoelektrischer Generator vorgeschlagen, der aus einer Mehrzahl der erfindungsgemäßen thermoelektrischen Module oder nach den erfindungsgemäßen Verfahren hergestellte thermoelektrische Module aufweist, die miteinander elektrisch verschaltet sind. Insbesondere wird ein thermoelektrisches Modul so in einem Gehäuse oder einem thermoelektrischen Generator angeordnet, dass zumindest die Kaltseite des thermoelektrischen Moduls mit ihren jeweiligen Enden räumlich fixiert angeordnet ist. Insbesondere ist weiterhin ein Ende der Heißseite räumlich fixiert, so dass eine Bewegung des Innenrohrs gegenüber dem Außenrohr nur durch eine Ausdehnung des an der Heißseite angeordneten Rohres realisiert wird. Insbesondere weist zumindest die Heißseite und ggf. auch die Kaltseite keine weiteren Kompensationsmöglichkeiten zum Abbau von Wärmedehnungen auf, z. B. Falzungen des Rohres o. ä. Die Erfindung findet insbesondere Anwendung in einem Kraftfahrzeug. Die Heißseite des thermoelektrischen Generators wird dabei mit Abgas des Motors des Kraftfahrzeugs umströmt, während die Kaltseite z. B. mit einem Wasserkreislauf gebildet ist.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: ein rohrförmiges thermoelektrisches Modul,
- Fig. 2:: einen Ausschnitt aus Fig. 1,
- Fig. 3:: eine weitere Ausführungsvariante eines rohrförmigen thermoelektrischen Moduls,
- Fig. 4:: Schritt a) eines Verfahrens zur Herstellung eines thermoelektrischen Moduls,
- Fig. 5:: Schritt b) eines Verfahrens zur Herstellung eines thermoelektrischen Moduls,
- Fig. 6:: Schritt c) eines Verfahrens zur Herstellung eines thermoelektrischen Moduls,
- Fig. 7:: Schritt d) eines Verfahrens zur Herstellung eines thermoelektrischen Moduls,
- Fig. 8:: die Anordnung eines Halbleiterelements zwischen streifenförmigen Strukturen,
- Fig. 9:: die Anordnung eines thermoelektrischen Moduls zwischen zwei Aufnahmen, und
- Fig. 10:: ein Kraftfahrzeug mit einem thermoelektrischen Generator.

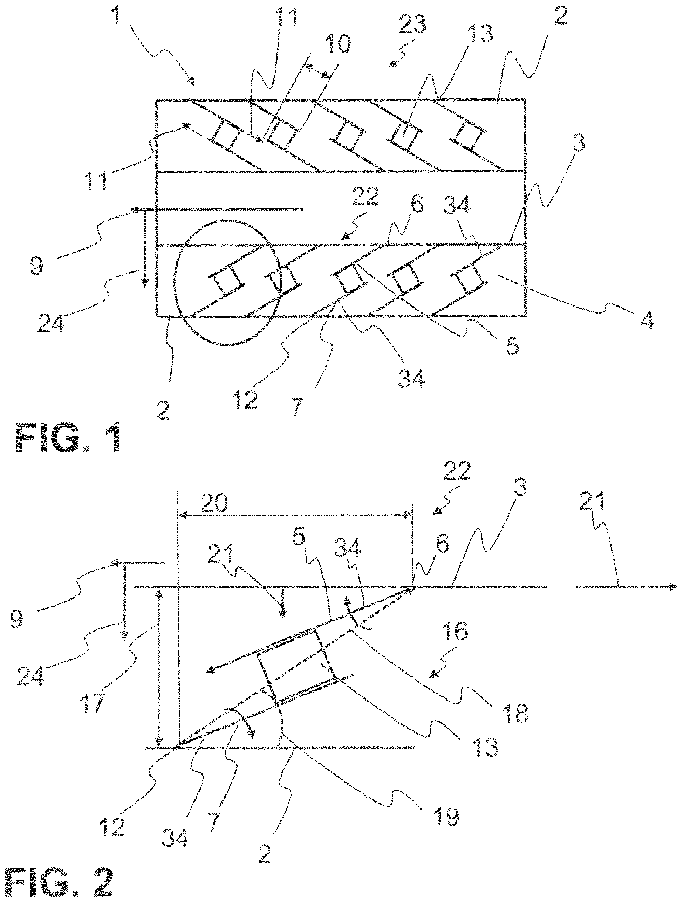

Fig. 1 zeigt ein thermoelektrisches Modul 1, das ein Außenrohr 2 und ein Innenrohr 3 aufweist, die sich in einer Längsrichtung 9 erstrecken. Das Innenrohr 3 ist dabei mit einer Heißseite 22 (z. B. dem Abgasstrom einer Verbrennungskraftmaschine) verbunden und das Außenrohr 2 mit einer Kaltseite 23. Zwischen Außenrohr 2 und Innenrohr 3 ist ein Zwischenraum 4 ausgebildet, in dem erste streifenförmige Strukturen 5 und zweite streifenförmige Strukturen 7 angeordnet sind. Diese ersten streifenförmigen Strukturen 5 sind über eine erste Anbindung 6, die in Umfangsrichtung verläuft, mit dem Innenrohr 3 verbunden. Die ersten streifenförmigen Strukturen 5 erstrecken sich von der ersten Anbindung 6 in Längsrichtung 9 und in radialer Richtung 24 in eine Richtung 11. Zweite streifenförmige Strukturen 7 sind über eine zweite Anbindung 12 mit dem Außenrohr 2 verbunden und erstrecken sich von der zweiten Anbindung 12 aus in eine entgegen gesetzte Richtung 11 hin zu den ersten streifenförmigen Strukturen 5. Zwischen einem Paar aus der ersten streifenförmigen Struktur 5 und der zweiten streifenförmigen Struktur 7 bildet sich eine Überdeckung 10 aus, innerhalb der Halbleiterelemente 13 angeordnet sind, die mit den ersten streifenförmigen Strukturen 5 und zweiten streifenförmigen Strukturen 7 verbunden sind.

Fig. 2 zeigt einen Ausschnitt aus Fig. 1, anhand dessen die Kompensation der Wärmeausdehnung veranschaulicht werden soll. Die erste streifenförmige Struktur 5 ist über eine erste Anbindung 6 mit dem Innenrohr 3 verbunden. Infolge der Anordnung des Innenrohrs 3 an der Heißseite 22 erfolgt eine Ausdehnung des Innenrohrs 3 sowohl in Längsrichtung 9 als auch in der radialen Richtung 24. Diese Wärmeausdehnung resultiert in einer Bewegung 21, die gegenüber dem Außenrohr 2 zu kompensieren ist. Die zweite streifenförmige Struktur 7 ist über eine zweite Anbindung 12 mit dem Außenrohr 2 verbunden und bildet mit der ersten streifenförmigen Struktur 5 eine Überdeckung 10, innerhalb der ein Halbleiterelement 13 angeordnet ist. Erste streifenförmige Struktur 5 und zweite streifenförmige Struktur 7 bilden damit ein Paar 16 aus. Das Paar 16 hat eine Segmenthöhe 17, die den Abstand in radialer Richtung 24 zwischen erster Anbindung 6 und zweiter Anbindung 12 definiert. Das Paar 16 weist weiter eine Segmentlänge 20 auf, die den Abstand in Längsrichtung 9 zwischen erster Anbindung 6 und zweiter Anbindung 12 definiert. Weiterhin weist das Paar 16 einen Diagonalenwinkel 19 auf, der zwischen Außenrohr 2 und einer Diagonalenlänge 18, die die erste Anbindung 6 und zweite Anbindung 12 verbindet, bzw. zwischen Innenrohr 3 und Diagonalenlänge 18 angeordnet ist.

Die Wärmeausdehnungen sowohl in Längsrichtung 9 als auch in radialer Richtung 24 werden nun durch die relative Bewegung 21 des Innenrohrs kompensiert, so dass eine auf die Halbleiterelemente 13 wirkende Scherspannung vermieden werden kann. Die Bewegung 21 des Innenrohres 3 in Längsrichtung 9 und in radialer Richtung 24 führt zu einer Veränderung des Diagonalenwinkels 19, der damit kleiner wird (s. Pfeilrichtung). Durch die Wärmeausdehnung des Innenrohres 3 in radialer Richtung 24 verändert sich zudem die Diagonalenlänge 18, so dass Scherspannungen in das Halbleiterelement induziert werden würden. Diese Veränderung der Diagonalenlänge 18 wird nun durch eine relative Bewegung 21 des Innenrohrs 3 ausgeglichen, die somit die erste Anbindung 6 von der zweiten Anbindung 12 entfernt. Dadurch bleibt die Diagonalenlänge 18 konstant und eine Scherspannung, die auf die Halbleiterelemente 13 wirken könnte, wird vermieden. Durch diese kombinierte Ausgleichsmöglichkeit, einerseits durch die mögliche relative Bewegung 21 des Innenrohrs 3 gegenüber dem Außenrohr 2 und andererseits durch die federnde Anordnung der streifenförmigen Strukturen 5, 7, werden keine Scherspannungen auf die Halbleiterelemente 13 übertragen, so dass diese keine strukturelle Belastung erfahren. Der Kompensationseffekt kommt insbesondere dadurch zustande, dass die Wärmedehnung der Halbleiterelemente auf den streifenförmigen Strukturen (also der Diagonale) auf die Wärmedehnung der Umgebung (also der Relativbewegung Innenrohr/Außenrohr) abgestimmt ist.

Es ist durch eine spezifische Auswahl der Parameter Diagonalenlänge 18 und Diagonalenwinkel 19 weiterhin möglich, die relative Bewegung 21 des Innenrohres 3 gegenüber dem Außenrohr 2 so zu reduzieren, dass eine Längenänderung in Längsrichtung 9 des an der Heißseite 22 angeordneten Rohres 2, 3 nur aufgrund der Wärmeausdehnung erfolgt und keine zusätzliche relative Bewegung 21 erforderlich ist, um die Wärmeausdehnung in radialer Richtung 24 zu kompensieren. Eine hohe Temperatur an einem der Rohre 2, 3 bewirkt eine Wärmeausdehnung in radialer Richtung 24 um eine relative Bewegung 21, die die Segmenthöhe 17 reduziert, und weiterhin eine Wärmeausdehnung in Längsrichtung 9 um eine relative Bewegung 21, die die Segmentlänge 20 vergrößert. Diese Wärmeausdehnungen und die entsprechenden relativen Bewegungen 21 umfassen insbesondere auch die zusätzlichen Wärmeausdehnungen der einzelnen Komponenten 34, z. B. der streifenförmigen Strukturen 5, 7 usw. Durch angepasste Ausgangsgrößen für Diagonalenlänge 18 und Diagonalenwinkel 19 können sich nun die für einen bestimmten Temperaturbereich bekannten Wärmeausdehnungen in radialer Richtung 24 und Längsrichtung 9 gegenseitig kompensieren. Diese Kompensation erfolgt vollständig, wenn die Verkürzung der Diagonalenlänge 18 infolge der Reduzierung der Segmenthöhe 17 durch die Verlängerung der Diagonalenlänge 18 infolge der Vergrößerung der Segmentlänge 20 ausgeglichen wird.

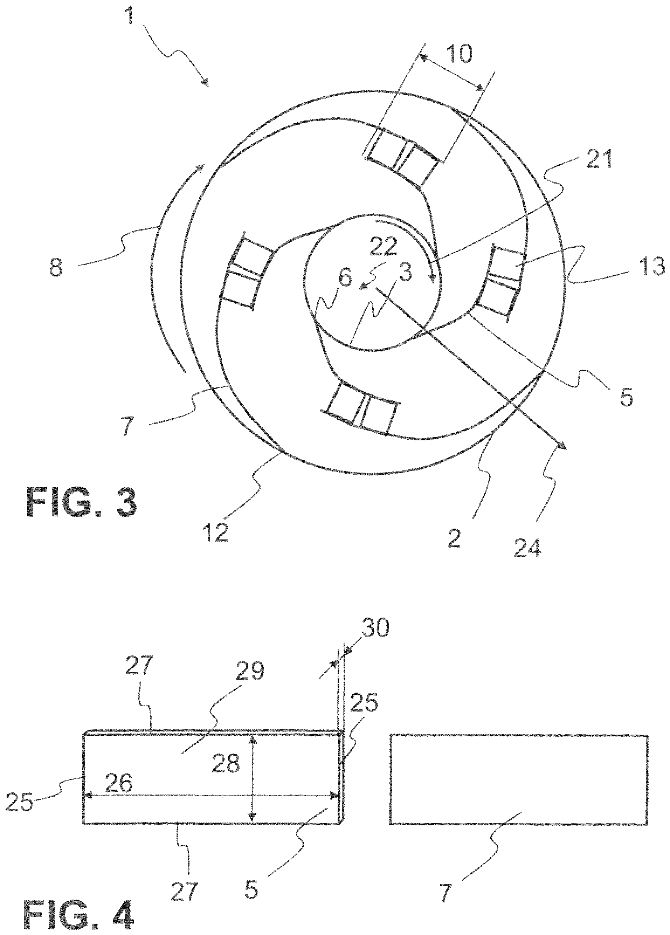

Fig. 3 zeigt eine weitere Ausführungsvariante eines thermoelektrischen Moduls 1, wobei das thermoelektrische Modul 1 ein kreisförmiges Außenrohr 2 und ein kreisförmiges Innenrohr 3 aufweist, mit in Umfangsrichtung 8 und in radialer Richtung 24 verlaufenden ersten streifenförmigen Strukturen 5 und zweiten streifenförmigen Strukturen 7. Diese ersten streifenförmigen Strukturen 5 und zweiten streifenförmigen Strukturen 7 bilden jeweils eine Überdeckung 10 aus, innerhalb der zwei Halbleiterelemente 13 angeordnet sind, die jeweils ein thermoelektrisches Element bilden. Eine Ausdehnung des mit einer Heißseite 22 verbundenen Innenrohrs 3 in radialer Richtung 24 wird einerseits durch eine evolventenförmige Anordnung der streifenförmigen Strukturen 5, 7 ausgeglichen und ggf. zusätzlich durch eine in Umfangsrichtung 8 gerichtete Bewegung 21 des Innenrohrs 3 gegenüber dem Außenrohr 2 kompensiert. Dadurch erfolgt gleichzeitig eine Kompensation der Ausdehnung der ersten streifenförmigen Struktur 5 in Folge der Erwärmung von der Heißseite 22. Die in Bezug auf Fig. 2 genannten Definitionen können entsprechend auf die Ausführung nach Fig. 3 übertragen werden. Durch die Ausdehnung des Innenrohrs 3 in der radialen Richtung 24 wird einerseits die Segmenthöhe reduziert und damit auch die Diagonalenlänge. Zum Ausgleich erfolgt eine relative Bewegung 21 des Innenrohrs 3 in Umfangsrichtung 8, so dass die Diagonalenlänge um ein entsprechendes Maß verlängert wird und Scherspannungen, die zu einer Zerstörung der Halbleiterelemente 13 führen können, verhindert werden. Durch eine schräge Anordnung der streifenförmigen Strukturen 5, 7 an dem Außenrohr 2 bzw. dem Innenrohr 3 kann zudem eine Längenausdehnung des Innenrohrs 3 gegenüber dem Außenrohr 2 kompensiert werden. Dies ist insbesondere bei einer wendelförmigen Anordnung der streifenförmigen Strukturen 5, 7 gewährleistet. Auch hier kann durch eine spezifische Auswahl der Parameter für Diagonalenlänge und Diagonalenwinkel eine zusätzliche relative Bewegung 21 des Innenrohres 3 zumindest teilweise vermieden werden, da die in Umfangsrichtung 8 erforderliche Bewegung 21 des Innenrohrs 3 zur Verlängerung der Diagonalenlänge dann durch eine Wärmeausdehnung des Innenrohrs 3 in Längsrichtung zumindest teilweise kompensiert wird.

Fig. 4 zeigt Verfahrensschritt a) zur Herstellung eines thermoelektrischen Moduls 1, wobei eine erste streifenförmige Struktur 5 und eine zweite streifenförmige Struktur 7 bereitgestellt werden. Die streifenförmigen Strukturen 5, 7 weisen zwischen zwei Enden 25 eine Länge 26 auf und zwischen zwei Seiten 27 eine Breite 28. Weiterhin wird die streifenförmige Struktur durch zwei Oberflächen 29 begrenzt, die mit einer Dicke 30 voneinander beabstandet sind.

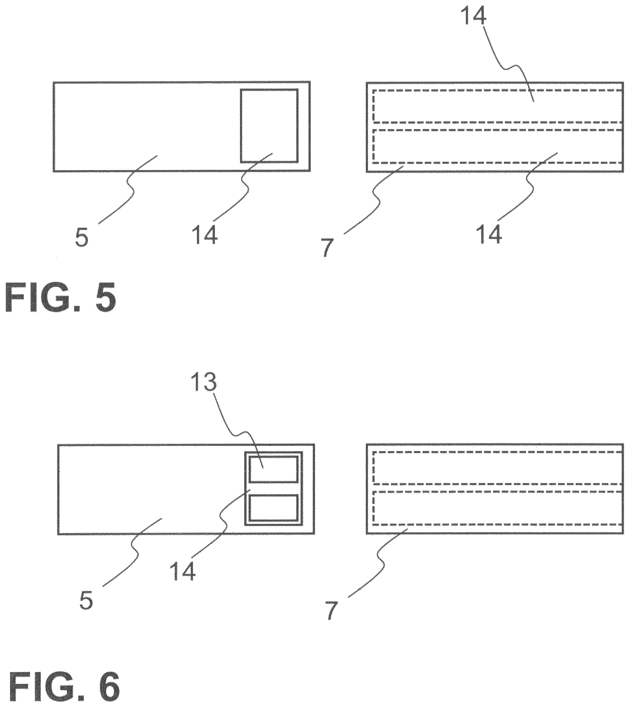

Fig. 5 zeigt Verfahrensschritt b) zur Herstellung eines thermoelektrischen Moduls 1, wobei elektrisch leitende Leiterstrukturen 14 auf die erste streifenförmige Struktur 5 und auf die zweite streifenförmige Struktur 7 aufgebracht sind. Die im rechten Teil des Bilds gezeigten gestrichelt ausgeführten Leiterstrukturen 14 sind auf der unten liegenden Oberfläche der zweiten streifenförmigen Struktur 7 angeordnet.

Fig. 6 zeigt Verfahrensschritt c) zur Herstellung eines thermoelektrischen Moduls 1, wobei Halbleiterelemente 13 auf der Leiterstruktur 14 der ersten streifenförmigen Struktur 5 aufgebracht sind.

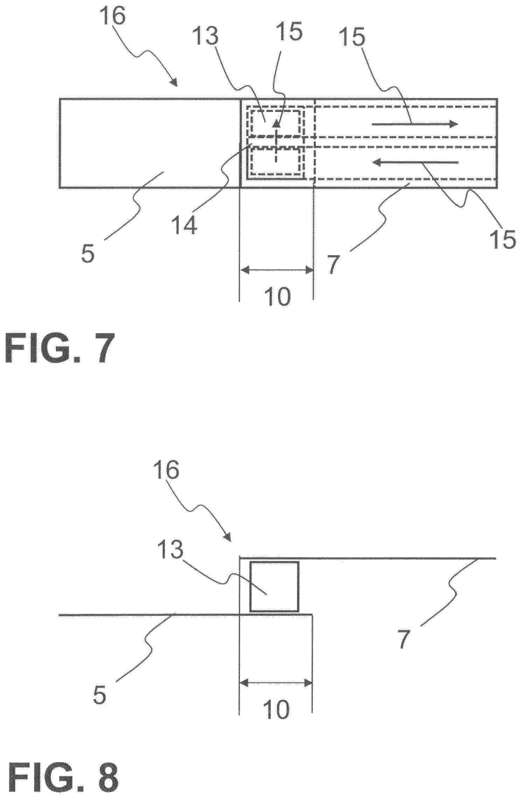

Fig. 7 zeigt den Verfahrensschritt d) zur Herstellung eines thermoelektrischen Moduls 1, wobei die erste streifenförmige Struktur 5 und die zweite streifenförmige Struktur 7 zu einem Paar 16 angeordnet sind, die eine Überdeckung 10 ausbilden, so dass Halbleiterelemente 13 zwischen der ersten streifenförmigen Struktur 5 und der zweiten streifenförmigen Struktur 7 auf den elektrisch leitenden Leiterstrukturen 14 angeordnet werden können. Dieses Paar 16 bildet damit ein thermoelektrisches Element, das bei Anlegen eines Temperaturpotentials zur Erzeugung eines elektrischen Stromflusses 15 geeignet ist.

Fig. 8 zeigt die Anordnung eines Halbleiterelements 13 zwischen den streifenförmigen Strukturen 5, 7, die ein Paar 16 bilden. Das Halbleiterelement 13 ist im Bereich der Überdeckung 10 angeordnet.

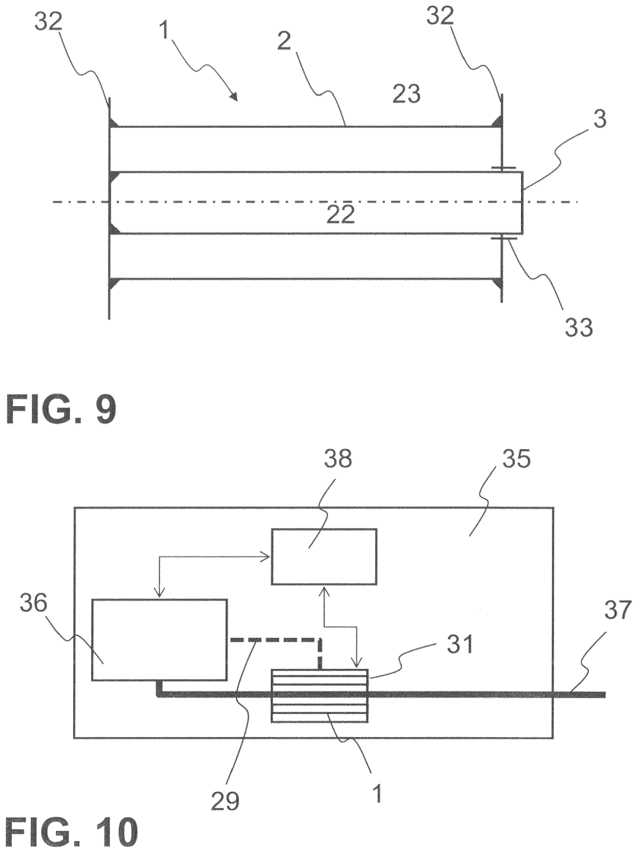

Fig. 9 zeigt die Anordnung eines thermoelektrischen Moduls 1 zwischen zwei Aufnahmen 32. Das Innenrohr 3 ist mit einer Heißseite 22 verbunden, das Außenrohr 2 mit einer Kaltseite 23. Das Innenrohr 3 ist entsprechend in der einen Aufnahme 32 mit einem Schiebesitz 33 ausgeführt, so dass eine relative Bewegung 21 des Innenrohrs 3 gegenüber dem Außenrohr 2 erfolgen kann.

Fig. 10 soll den bevorzugten Einsatz der Erfindung in einem Kraftfahrzeug 35 veranschaulichen. Das Kraftfahrzeug 35 hat dabei eine Verbrennungskraftmaschine 36 oder eine andere Wärmequelle. Das in der Verbrennungskraftmaschine 36 erzeugte heiße Abgas wird durch eine Abgasleitung 37 hindurch geführt, wobei es auch einen thermoelektrischen Generator 31 durchströmt, der mehrere (rohrförmige) thermoelektrische Module 1 umfasst. Weiterhin ist der thermoelektrische Generator 31 mit einer Kühlleitung 39 (beispielsweise einem Wasser-Motorkühlkreis) verbunden, so dass mit dem Abgas eine Heißseite und dem Kühlmittel eine Kaltseite des thermoelektrischen Generators 31 beströmt werden kann. Dies kann mit einer Kontrolleinheit 38 eingerichtet und/oder überwacht werden, so dass von dort, ggf. über Rückkoppelung über den Betrieb des Abgassystems und/oder der Verbrennungskraftmaschine (angedeutet durch die Pfeile), der Betrieb des thermoelektrischen Generators 31 erfolgen kann.

Die vorliegende Erfindung löst somit zumindest teilweise die mit Bezug auf den Stand der Technik geschilderten Probleme. Insbesondere ist ein rohrförmiges thermoelektrisches Modul angegeben, das die unterschiedlichen Wärmeausdehnungen einzelner Komponenten des thermoelektrischen Moduls kompensieren kann und so eine hohe Dauerfestigkeit des thermoelektrischen Moduls auch im Betrieb erreicht. So wurde ein temperaturbeständiges und dauerfestes thermoelektrisches Modul aufgezeigt.

### Bezugszeichenliste

- 1: thermoelektrisches Modul
- 2: Außenrohr
- 3: Innenrohr
- 4: Zwischenraum
- 5: erste streifenförmige Struktur
- 6: erste Anbindung
- 7: zweite streifenförmige Struktur
- 8: Umfangsrichtung
- 9: Längsrichtung
- 10: Überdeckung
- 11: Richtung
- 12: zweite Anbindung
- 13: Halbleiterelement
- 14: Leiterstrukturen
- 15: Stromfluss
- 16: Paar
- 17: Segmenthöhe
- 18: Diagonalenlänge
- 19: Diagonalenwinkel
- 20: Segmentlänge
- 21: Bewegung
- 22: Heißseite
- 23: Kaltseite
- 24: radiale Richtung
- 25: Ende
- 26: Länge
- 27: Seite
- 28: Breite
- 29: Oberfläche
- 30: Dicke
- 31: thermoelektrischer Generator
- 32: Aufnahme
- 33: Schiebesitz
- 34: Komponente
- 35: Kraftfahrzeug
- 36: Verbrennungskraftmaschine
- 37: Abgasleitung
- 38: Kontrolleinheit
- 39: Kühlleitung

## Patentansprüche

1. Thermoelektrisches Modul (1), dass sich in einer Längsrichtung (9) erstreckt, mit einem Außenrohr (2) und einem innerhalb des Außenrohrs (2) angeordneten Innenrohr (3) sowie einem dazwischen angeordneten Zwischenraum (4), wobei zumindest eine erste streifenförmige Struktur (5) und eine zweite streifenförmige Struktur (7) vorgesehen sind, die erste streifenförmige Struktur (5) sich ausgehend von einer ersten Anbindung (6) am Innenrohr (3) und die zweite streifenförmige Struktur (7) sich ausgehend von einer zweiten Anbindung (12) am Außenrohr (2) in jeweils entgegen gesetzten Richtungen (11) in einer radialen Richtung (24) hin zum gegenüberliegenden Rohr (2, 3) und zusätzlich zumindest in einer Umfangsrichtung (8) oder der Längsrichtung (9) erstrecken und zumindest in Umfangsrichtung (8) oder in Längsrichtung (9) wenigstens teilweise eine Überdeckung (10) ausbilden, wobei im Bereich der Überdeckung (10) zumindest ein Paar Halbleiterelemente (13) angeordnet ist, **dadurch gekennzeichnet, dass** die erste Anbindung (6) und die zweite Anbindung (12) schräg zur Umfangsrichtung (8) bzw. zur Längsrichtung (9) des thermoelektrischen Moduls angeordnet sind.

2. Thermoelektrisches Modul (1) nach Patentanspruch 1, wobei das Außenrohr (2) und das Innenrohr (3) so zueinander angeordnet sind, dass eine thermische Ausdehnung des Moduls (1) durch eine relative Bewegung (21) des Außenrohres (2) gegenüber dem Innenrohr (3) kompensiert wird.

3. Thermoelektrisches Modul (1) nach einem der vorhergehenden Patentansprüche, wobei die ersten Anbindungen (6) auf dem Innenrohr (3) und die zweiten Anbindungen (12) auf dem Außenrohr (2) wendelförmig verlaufen.

4. Thermoelektrisches Modul (1) nach einem der vorhergehenden Patentansprüche, wobei zumindest in Umfangsrichtung (8) oder in Längsrichtung (9) des thermoelektrischen Moduls (1) mehrere Strukturen (5) angeordnet sind.

## Claims

1. Thermoelectric module (1) which extends in a longitudinal direction (9), having an outer tube (2), an inner tube (3) arranged within the outer tube (2), and an interspace (4) arranged therebetween, wherein at least one first strip-shaped structure (5) and one second strip-shaped structure (7) are provided, the first strip-shaped structure (5), which starts from a first connection (6) to the inner tube (3), and the second strip-shaped structure, which starts from a second connection (12) to the outer tube (2), extend in mutually opposite directions (11) in a radial direction (24) toward the opposite tube (2, 3) and additionally at least in one circumferential direction (8) or the longitudinal direction (9), and form an at least partial overlap (10), at least in the circumferential direction (8) or in the longitudinal direction (9), wherein at least one pair of semiconductor elements (13) is arranged in the region of the overlap (10), **characterized in that** the first connection (6) and the second connection (12) are arranged obliquely to the circumferential direction (8) or to the longitudinal direction (9) of the thermoelectric module.

2. Thermoelectric module (1) according to Patent Claim 1, wherein the outer tube (2) and the inner tube (3) are arranged in such a way relative to one another that a thermal expansion of the module (1) is compensated for by a movement (21) of the outer tube (2) relative to the inner tube (3).

3. Thermoelectric module (1) according to one of the preceding patent claims, wherein the first connections (6) extend in a helical shape on the inner tube (3) and the second connections (12) extend in a helical shape on the outer tube (2).

4. Thermoelectric module (1) according to one of the preceding patent claims, wherein a plurality of structures (5) is arranged at least in the circumferential direction (8) or in the longitudinal direction (9) of the thermoelectric module (1).

## Revendications

1. Module thermoélectrique (1), qui s'étend dans une direction longitudinale (9), comprenant un tube externe (2) et un tube interne (3) disposé à l'intérieur du tube externe (2) ainsi qu'un espace intermédiaire (4) disposé entre ceux-ci, au moins une première structure en forme de bande (5) et une deuxième structure en forme de bande (7) étant présentes, la première structure en forme de bande (5) s'étendant à partir d'une première connexion (6) au tube interne (3) et la deuxième structure en forme de bande (7) à partir d'une deuxième connexion (12) au tube externe (2), respectivement dans des directions opposées (11) dans une direction radiale (24) jusqu'au tube à l'opposé (2, 3), et en plus au moins dans une direction circonférentielle (8) ou dans la direction longitudinale (9), et formant au moins partiellement un recouvrement (10) au moins dans la direction circonférentielle (8) ou dans la direction longitudinale (9), au moins une paire d'éléments semiconducteurs (13) étant disposée dans la zone du recouvrement (10), **caractérisé en ce que** la première connexion (6) et la deuxième connexion (12) sont disposées en biais par rapport à la direction circonférentielle (8) ou à la direction longitudinale (9) du module thermoélectrique.

2. Module thermoélectrique (1) selon la revendication 1, le tube externe (2) et le tube interne (3) étant disposés l'un par rapport l'autre de telle sorte qu'une dilatation thermique du module (1) est compensée par un mouvement relatif (21) du tube externe (2) par rapport au tube interne (3).

3. Module thermoélectrique (1) selon l'une des revendications précédentes, les premières connexions (6) sur le tube interne (3) et les deuxièmes connexions (12) sur le tube externe (2) s'étendant de manière hélicoïdale.

4. Module thermoélectrique (1) selon l'une des revendications précédentes, plusieurs structures (5) étant disposées au moins dans la direction circonférentielle (8) ou dans la direction longitudinale (9) du module thermoélectrique (1) .
